# EUROPEAN PATENT APPLICATION

(11) **EP 4 335 605 A1**
(43) Date of publication of application: **13.03.2024**
(21) Application number: 23190629.8
(22) Date of filing: 09.08.2023
(51) Int. Cl.: B29C 33/00, B29C 59/02, G03F 7/00

(54) **METHOD OF MANUFACTURING STRUCTURE**

(30) Priority: 30.08.2022 JP 2022137294
(71) Applicant: FUJIFILM Corporation, Tokyo 106-8620 (JP)
(72) Inventor: UMEZAWA, Tomokazu, Minamiashigara, 250-0193 (JP)
(74) Representative: Meissner Bolte Partnerschaft mbB

(57) **Abstract**

Provided is a method of manufacturing a structure using a mold and having excellent transfer accuracy.

The method of manufacturing the structure includes: a step of providing a transfer material; a step of shaping the transfer material on a substrate by using a mold for structure shaping, which has a first member that has two main surfaces and a through-hole which penetrates through the main surfaces and a second member that blocks the through-hole, and in which the first member and the second member are combined such that a wall surface A, which is a part of a surface of the first member, and a wall surface B, which is a part of a surface of the second member, are made continuous to form a mold wall; a step of exposing a part of the structure on which the transfer material is shaped, or a part of the structure on which the transfer material is shaped and a part of the substrate by removing the second member from the mold; and a step of separating the first member and the structure from each other by pressing at least a part of an exposed part of the structure or an exposed part of the substrate.

## Description

### BACKGROUND OF THE INVENTION

### 1. Field of the Invention

The present disclosure relates to a method of manufacturing a structure.

### 2. Description of the Related Art

Various techniques for forming a microstructre using a forming die (mold) have been studied.

For example, JP2012-82096A describes a method of manufacturing a glass molded body includes steps of: fitting a first fitting portion, which includes a surface constituting a part of a reception surface that receives molten glass, into an outer peripheral portion which includes a surface constituting another part of the reception surface; forming the reception surface; supplying the molten glass to the reception surface; forming a molten glass gob on the reception surface; removing the first fitting portion from the outer peripheral portion; a step of disposing the molten glass gob, which is on the outer peripheral portion, on a molding surface different from the reception surface; and forming the molten glass gob into the glass molded body on the molding surface. In the description, the glass molded body obtained by the manufacturing method is used as an optical lens or the like included in an optical element.

### SUMMARY OF THE INVENTION

In a case where a transfer material is shaped on a substrate using a mold to manufacture a structure, it may be difficult to release and separate the structure from the mold by separating the mold. In particular, in the manufacturing of a microstructre or the like having a large aspect ratio, it is difficult to separate the structure from the mold without damaging the structure, and there is a high tendency that favorable transfer accuracy cannot be obtained.

The present disclosure has been made in consideration of the circumstances described above.

According to an embodiment of the present disclosure, it is an object to provide a method of manufacturing a structure using a mold and having excellent transfer accuracy.

The present disclosure includes the following aspects.
[1] A method of manufacturing a structure comprises:
   a step of providing a transfer material;
   a step of shaping the transfer material on a substrate by using a mold for structure shaping, which has a first member that has two main surfaces and a through-hole which penetrates through the main surfaces and a second member that blocks the through-hole, and in which the first member and the second member are combined such that a wall surface A, which is a part of a surface of the first member, and a wall surface B, which is a part of a surface of the second member, are made continuous to form the mold wall;
   a step of exposing a part of the structure on which the transfer material is shaped, or a part of the structure on which the transfer material is shaped and a part of the substrate by removing the second member from the mold; and
   a step of separating the first member and the structure from each other by pressing at least a part of an exposed part of the structure or an exposed part of the substrate.
[2] In the method of manufacturing the structure according to [1], in the step of separating the first member and the structure from each other, pressing against at least a part of the exposed part of the structure or at least a part of the exposed part of the substrate is performed by using at least one selected from the group consisting of a pressing member, a gas, and a liquid capable of being inserted into the through-hole of the first member.
[3] In the method of manufacturing the structure according to [1] or [2], in the step of separating the first member and the structure from each other, pressing against an entirety of the exposed part of the structure or an entirety of the exposed part of the substrate is performed once.
[4] In the method of manufacturing the structure according to [1] or [2], in the step of shaping the transfer material, a plurality of the structures are shaped, and in the step of separating the first member and the structure from each other, pressing against the exposed part of the structure or the exposed part of the substrate is performed stepwise multiple times.
[5] In the method of manufacturing the structure according to any one of [1] to [4], the pressing includes pressing using the pressing member.
[6] In the method of manufacturing the structure according to [5], the pressing member is a pressing pin.
[7] In the method of manufacturing a structure according to [5] or [6], the mold for structure shaping is a mold for structure shaping in which the wall surface A is a surface of the through-hole and the wall surface A and the first member and the second member are combined such that the wall surface A and the wall surface B are made continuous to form the mold wall, and a length of the pressing member along a pressing direction is longer than a penetration length of the through-hole of the first member along the pressing direction.
[8] In the method of manufacturing the structure according to any one of [5] to [7], the mold for structure shaping is a mold for structure shaping in which the wall surface A is a surface of the through-hole and the wall surface A and the first member and the second member are combined such that the wall surface A and the wall surface B are made continuous to form the mold wall, and the through-hole of the first member includes a through-hole having an aspect ratio of 2 to 20, which is a penetration length with respect to an opening width.

According to an embodiment of the present disclosure, it is possible to provide the method of manufacturing the structure using the mold and having excellent transfer accuracy.

### BRIEF DESCRIPTION OF THE DRAWINGS

Fig. 1A is a diagram for explaining an example of a method of manufacturing a structure according to the present disclosure.
Fig. 1B is a diagram for explaining an example of the method of manufacturing the structure according to the present disclosure.
Fig. 2Ais a schematic cross-sectional view showing an example of a mold used in the method of manufacturing the structure according to the present disclosure.
Fig. 2B is a top view showing an example of a first member.
Fig. 2C is a schematic cross-sectional view taken along the line 1-1 of the first member shown in Fig. 2B.
Fig. 2D is a top view showing an example of a second member.
Fig. 2E is a schematic cross-sectional view taken along the line 2-2 of the second member shown in Fig. 2D.
Fig. 3A is a top view showing an example of the first member having two or more through-holes.
Fig. 3B is a schematic cross-sectional view taken along the line 3-3 of the first member shown in Fig. 3A.
Fig. 4 is a schematic cross-sectional view showing another example of the mold in the present disclosure.
Fig. 5 is a schematic cross-sectional view showing an example of one-step pressing in a separation step.
Figs. 6A and 6B is a schematic cross-sectional view showing an example of multi-step pressing in the separation step.
Fig. 7A is a schematic cross-sectional view showing another example of the mold in the present disclosure.
Fig. 7B is a schematic cross-sectional view showing an example of the mold in which a room separate from a room defined by the mold wall is formed.
Fig. 8 is a schematic cross-sectional view showing an example of the mold having an alignment portion.

### DESCRIPTION OF THE PREFERRED EMBODIMENTS

Hereinafter, embodiments of the present disclosure will be described with reference to the accompanying drawings. The present disclosure is not limited in any way to the following embodiments and may be implemented with appropriate modifications within the scope of the purpose of the present disclosure. The constitutional elements indicated by the same reference numerals in the drawings mean the same constitutional elements. The description of redundant constitutional elements and reference numerals in the respective drawings may be omitted. A dimensional ratio in the drawings does not necessarily represent the actual dimensional ratio.

In the present disclosure, a range of numerical values described using "to" means a range including the numerical values listed before and after "to" as the lower limit value and the upper limit value. In the numerical range described stepwise in the embodiment of the present disclosure, an upper limit value or a lower limit value described in a certain numerical range may be replaced with an upper limit value or a lower limit value of another numerical range described stepwise. Further, in the numerical range described in the embodiment of the present disclosure, the upper limit value or the lower limit value described in a certain numerical range may be replaced with a value shown in examples.

### Method of Manufacturing Structure

A method of manufacturing the structure according to the present disclosure comprises the following steps:
a step of providing the transfer material (also referred to as a "transfer material provision step");
a step (hereinafter, also referred to as a shaping step) of shaping the transfer material on a substrate by using a mold for structure shaping (also referred to as a "specific mold"), which has a first member that has two main surfaces and a through-hole which penetrates through the main surfaces and a second member that blocks the through-hole, and in which the first member and the second member are combined such that a wall surface A, which is a part of a surface of the first member, and a wall surface B, which is a part of a surface of the second member, are made continuous to form a mold wall;
a step (also referred to as an "exposure step") of exposing a part of the structure on which the transfer material is shaped, or a part of the structure on which the transfer material is shaped and a part of the substrate by removing the second member from the mold; and
a step (also referred to as a "separation step") of separating the first member and the structure from each other by pressing at least a part of an exposed part of the structure or an exposed part of the substrate.

The method of manufacturing the structure according to the present disclosure is a method of manufacturing the structure by shaping the transfer material through the mold. By using the specific mold, a structure having excellent transfer accuracy can be manufactured through the above-mentioned transfer material provision step, shaping step, exposure step, and separation step.

The method of manufacturing the structure according to the present disclosure may include steps other than the transfer material provision step, the shaping step, the exposure step, and the separation step. Examples of the other steps include a surface treatment step, a cleaning step, and the like.

The method of manufacturing the structure according to the present disclosure can be suitably used for manufacturing a microstructure.

Here, in the present disclosure, the "microstructure" means a structure which is processed to have a size of nano-order or micron-order. Examples of the structure which is manufactured by the method of manufacturing the structure according to the present disclosure include a structure having a maximum length of 100 nm to 1000 µm. Thus, a structure having a maximum length of 5 µm to 200 µm is preferable. Examples of the structure include a microchannel, a cell culture vessel, a microlens array, a micromirror, and the like.

As described above, in a case where a transfer material is shaped on a substrate using a mold to manufacture a structure, it may be difficult to release and separate the structure from the mold by separating the mold. In particular, in the manufacturing of an elongated structure having a large aspect ratio or the like, it is difficult to separate the structure from the mold without damaging the structure, and there is a high tendency that favorable transfer accuracy cannot be obtained.

Therefore, the present inventor has addressed a configuration of the mold for structure shaping and the step of releasing and separating the structure from the mold. That is, in the method of manufacturing the structure according to the present disclosure, a transfer material is shaped on a substrate using the specific mold having the first member and the second member, and then the second member is removed, and thereby a part of the structure (that is, a molded body) or a part of the structure and a part of the substrate are exposed from the opening portion of the first member. By separating the first member and the structure from each other while pressing the exposed structure or the substrate, it is possible to improve the releasability of the structure from the mold. Thereby, since damage to the structure during separation from the mold can be suppressed, the structure (for example, the structure having the elongated shape with a large aspect ratio) can be manufactured with high transfer accuracy by using the mold.

JP2012-82096A does not addressed the specific mold used in the production method according to the present disclosure and steps corresponding to the above-mentioned steps.

Hereinafter, embodiments of the present disclosure will be described.

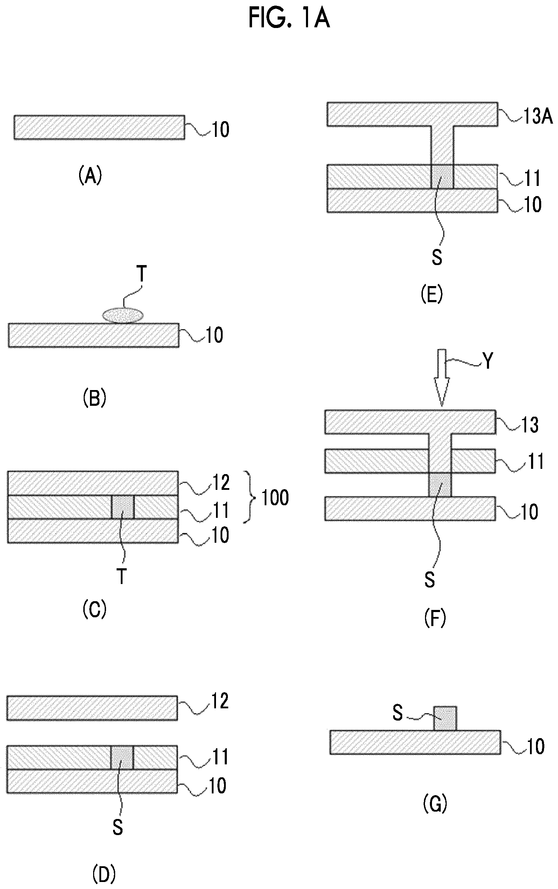

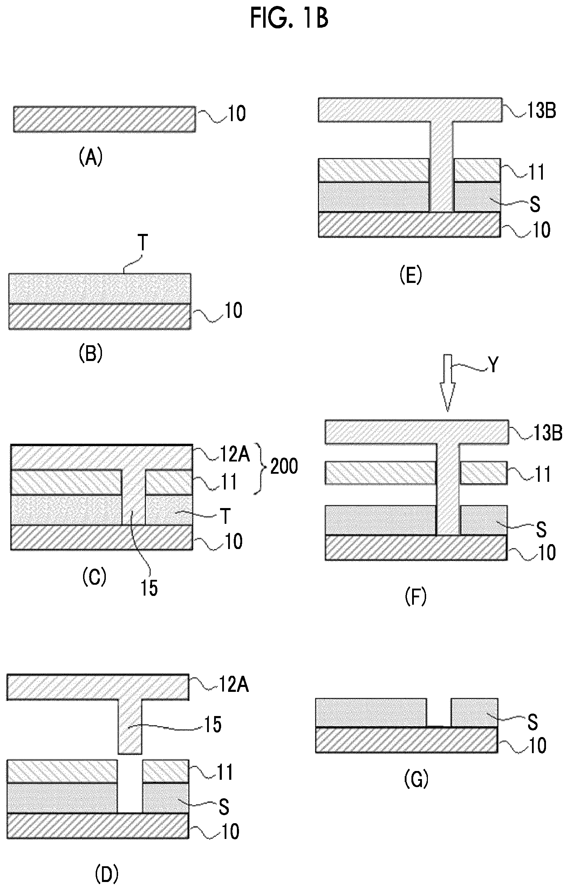

Fig. 1A ((A) to (G) of Fig. 1A)) and Fig. 1B ((A) to (G) of Fig. 1B) are diagrams showing an example of the method of manufacturing the structure according to the present disclosure. Hereinafter, each step of the method of manufacturing the structure according to the present disclosure will be described with reference to Figs. 1A and 1B as appropriate. However, the method of manufacturing the structure according to the present disclosure is not limited to the items exemplified in Figs. 1A and 1B.

### Transfer Material Provision Step

In the transfer material provision step, a transfer material used for manufacturing the structure is provided. The transfer material may be manufactured from a raw material or a commercially available product on the market may be used.

It is preferable that examples of the transfer material include a radiation-curable composition, a photocurable composition, a thermosetting composition, a thermoplastic resin, and a photocurable composition. As the photocurable composition, an ultraviolet (UV) curable composition is preferable. Examples of the ultraviolet curable composition include PAK-01 and PAK-02 which are manufactured by Toyo Synthetic Industry Co., Ltd.

### Shaping Step

In the shaping step, the wall surface A that includes a first member that has two main surfaces and a through-hole which penetrates through the main surfaces, and a second member that blocks the through-hole, and the transfer material is shaped on the substrate by using the mold for structure shaping (specific mold), in which the first member and the second member are combined such that the wall surface A, which is a part of the surface of the first member, and the wall surface B, which is a part of the surface of the second member, are made continuous to form the mold wall.

In the present disclosure, the "mold wall" means a surface of the surfaces of the mold that comes into contact with the transfer material and contributes to the shaping of the transfer material.

In the present disclosure, the wall surface A means a surface of the surfaces of the first member that comes into contact with the transfer material, and the wall surface B means a surface of the surfaces of the second member that comes into contact with the transfer material.

Further, in the present disclosure, the phrase "the wall surface A and the wall surface B are made continuous to form a mold wall" means that a mold wall is formed by making the wall surface A and the wall surface B come in contact with each other to form one surface. Specifically, in the step of manufacturing the structure, the wall surface A and the wall surface B may be in contact with each other to such an extent that the transfer material shaped by the molding does not leak from the contact portion between the wall surface A and the wall surface B.

The mold (specific mold) used in the method of manufacturing the structure according to the present disclosure will be described.

In an embodiment of the specific mold, the first member and the second member may be combined such that the wall surface A is a surface of the through-hole of the first member and the wall surface A and the wall surface B are made continuous to form the mold wall. (Hereinafter, the mold according to this embodiment is also appropriately referred to as a "mold A").

In another embodiment of the specific mold, the second member has a protrusion portion which penetrates and plugs the through-hole of the first member and of which a length in a cross-sectional view in a thickness direction is greater than a length of the through-hole, the wall surface B includes a surface of the protrusion portion, and the first member and the second member are combined such that the wall surface A and the wall surface B are made continuous to form the mold wall. (Hereinafter, the mold according to this embodiment is also appropriately referred to as a "mold B").

In the following description, in a case where the mold according to the embodiment is also simply referred to as the "mold" or "specific mold", the term "mold" or "specific mold" is used to include both the mold A and the mold B.

An embodiment shown in Fig. 1A is an example in which the mold A is used, and a mold 100 in which a first member 11 and a second member 12 are combined is used.

An embodiment shown in Fig. 1B is an example in which the mold B is used, and a mold 200, in which the first member 11 and a second member 12A having a protrusion portion 15 are combined, is used.

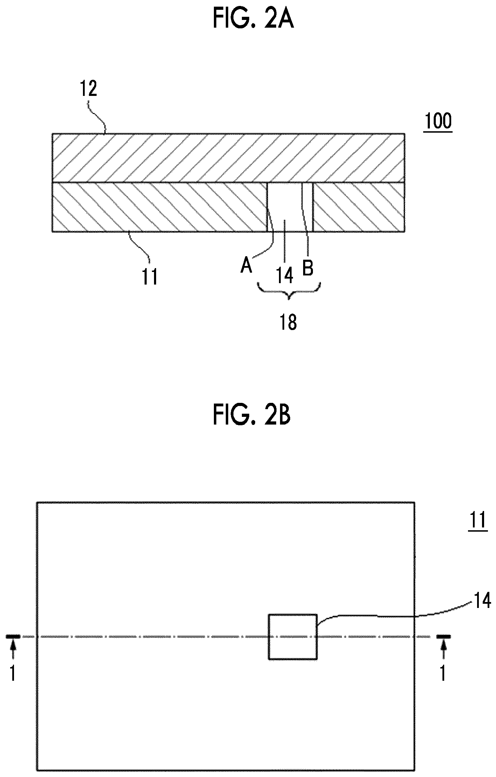

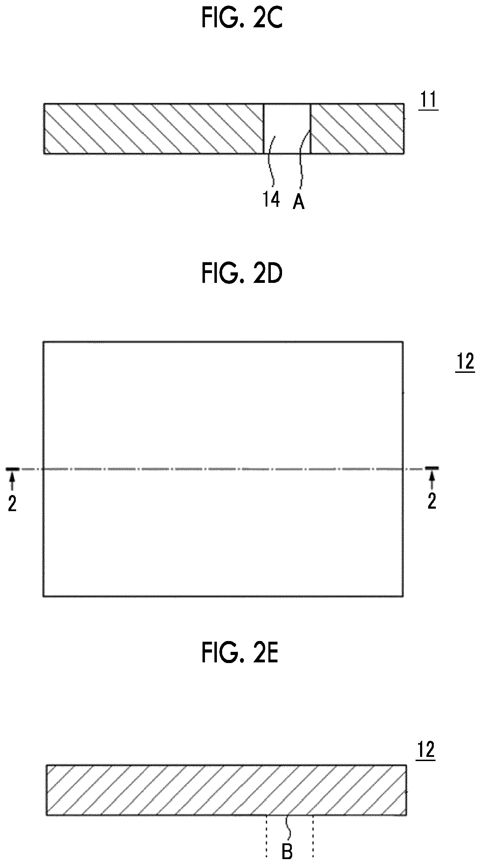

Fig. 2A is a schematic cross-sectional view showing the mold 100 according to the embodiment of the specific mold (mold A). Fig. 2B is a top view of the first member 11 of the mold 100, and Fig. 2C is a schematic cross-sectional view taken along the line 1-1 of the first member 11 shown in Fig. 2B. Fig. 2D is a top view of the second member 12 of the mold 100, and Fig. 2E is a schematic cross-sectional view taken along the line 2-2 of the second member 12 shown in Fig. 2D.

As shown in Fig. 2A, the mold 100 is configured as one mold by combining the first member 11 and the second member 12. The first member 11 is a member having two main surfaces and has a through-hole 14 which penetrates the two main surfaces. In the mold 100, the wall surface A of the through-hole 14 of the first member 11 and the wall surface B which is a part of the surface of the second member 12 are made continuous to form the mold wall. The mold wall, which is formed by the wall surface A and the wall surface B of the mold 100, regulates the transfer material (not shown in the drawing) filled in the through-hole 14 to shape the structure.

As shown in Figs. 2B and 2C, the first member 11 is a member having two main surfaces, and the two main surfaces of the first member having the through-holes 14 which penetrates the two main surfaces mean two flat surfaces of the first member facing each other in the thickness direction.

The first member 11 has only the through-hole 14, but may have one or two or more recessed portions (non-through-holes) which do not penetrate one of the two main surfaces in addition to the through-hole 14. In a case where the first member is provided with the non-through-hole, a structure to be subjected to the surface treatment and a structure not to be subjected to the surface treatment can be formed by using one mold.

In the mold 100, the entire surface of the through-hole 14 of the first member 11 constitutes the wall surface A, and the surface of the second member 12A that blocks the through-hole 14 constitutes the wall surface B. In the mold 100, a region including the mold wall, in which the wall surface A and the wall surface B are continuously formed, constitutes a pattern portion 18, as shown in Fig. 2A. The pattern portion 18 defines a shape and a size of the structure formed by using the mold 100. In the first member 11, the through-hole 14 is formed in a square column shape. However, the shape of the through-hole 14 is not limited to this, and may be a desired shape such as a columnar shape, a barrel shape, a polygonal column shape other than a square column shape, or a linear pattern.

The second member 12 is a member that blocks the through-hole 14 of the first member 11, and shapes one end (that is, a ceiling part of the structure) of the structure formed by filling the through-hole 14 with a transfer material (not shown in the drawing) in the mold 100.

As shown in Figs. 2D and 2E, the second member 12 is a planar member. In a case where the second member 12 is combined with the first member 11, a region (that is, a region between two virtual one-point broken lines in Fig. 2E) on one main surface of the second member 12 corresponding to the opening portion of the through-hole 14 of the first member 11 constitutes the wall surface B.

In the first member 11, a penetration length of the through-hole can be appropriately determined in accordance with the target structure. From the viewpoint of releasability of the structure, the penetration length may be, for example, in a range of 100 nm to 1000 µm, and preferably in a range of 5 µm to 200 µm.

An aspect ratio, which is a penetration length with respect to an opening width of the through-hole, can be appropriately determined in accordance with the target structure. From the viewpoint of releasability of the obtained structure, the first member may include, for example, a through-hole having an aspect ratio of 0.5 to 50, preferably includes a through-hole having an aspect ratio of 1 to 20, and more preferably include a through-hole having an aspect ratio of 2 to 20.

In the method of manufacturing the structure according to the present disclosure, damage to the structure is effectively suppressed in a case where the first member and the structure are separated in a separation step to be described later. Thus, a structure having a large aspect ratio can be manufactured with favorable transfer accuracy.

The first member 11 has one through-hole 14, but in the specific mold, the first member may have only one through-hole or two or more through-holes.

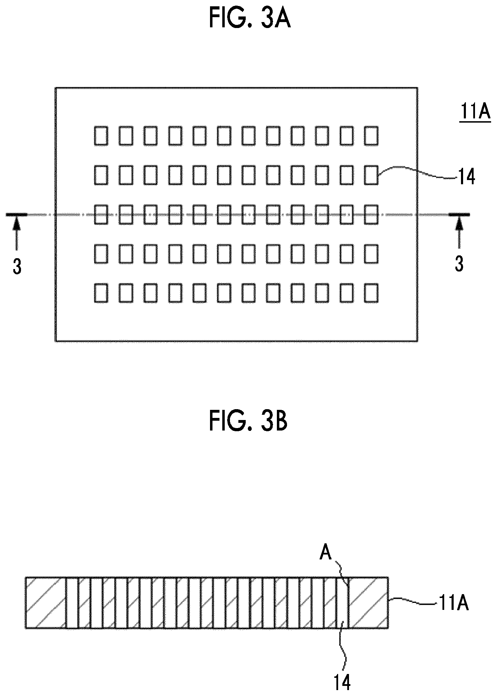

Figs. 3A and 3B shows an example of the first member having two or more through-holes. Fig. 3A is a top view of a first member 11A, and Fig. 3B is a schematic cross-sectional view taken along the line 3-3 of the first member 11A shown in Fig. 3A. The first member 11A shown in Figs. 3A and 3B is a modification example configured to be the same as the first member 10 except that the first member 10 of the mold 100 is changed to a configuration including two or more through-holes 14 (the number of through-holes: 12).

In the first member 11A, all of the through-holes 14 are formed in a square column shape. However, the shape of the through-hole 14 is not limited to this, and may be a desired shape such as a columnar shape, a barrel shape, a polygonal column shape other than a square column shape, or a linear pattern.

In a case where the first member has two or more through-holes, an aspect in which the through-holes are disposed is not particularly limited. The first member may have two or more through-holes on the entire surface (for example, in the form of the first member 11A), or may have two or more through-holes in a part of the first member.

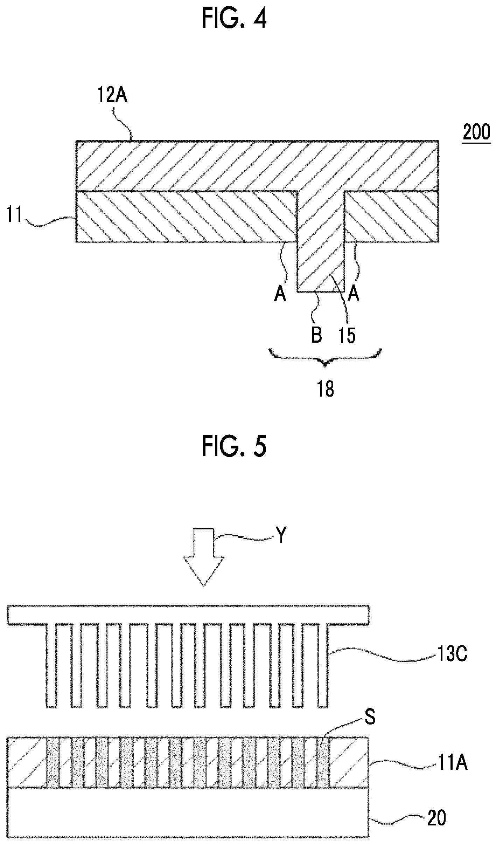

Fig. 4 is a schematic cross-sectional view showing the mold 200 according to the embodiment of the mold B. As shown in Fig. 4, the mold 200 is configured as one mold by combining the first member 11 and the second member 12A.

The first member 11 of the mold 200 is the same member as the first member 11 which constitutes the mold 100. In Fig. 4, the reference numerals of through-holes of the first member 11 are omitted. The second member 12A has a protrusion portion 15 of which the length in the cross-sectional view in the thickness direction is greater than the length of a through-hole of the first member 11, and the protrusion portion 15 penetrates and plugs the through-hole of the first member 11. That is, a part including the tip part of the protrusion portion 15 that plugs the through-hole of the first member 11 protrudes from the main surface of the first member 11 on the side opposite to the second member 12A side.

In the mold 200, the main surface on the side opposite to the second member 12A side in the two main surfaces of the first member 11 constitutes the wall surface A. The wall surface A and the wall surface B which is a part of the surface of the protrusion portion 15 of the second member 12A are made continuous to form the mold wall. In the mold 200, the pattern portion 18 is constituted by a region which includes the mold wall formed by continuously forming the wall surface A including the main surface on a side opposite to the second member 12A side and the wall surface B which is a part of the surface of the protrusion portion 15.

In the mold 200, a transfer material (not shown in the drawing) may be disposed on a side of the first member 11 opposite to the second member 12A side, and the transfer material can be regulated by the formed mold wall to shape the structure. By using the mold 200, it is possible to obtain a structure having a recessed portion (for example, a groove portion).

In addition, the mold according to the present disclosure may have only a configuration of the mold A or a configuration of the mold B, or may have a configuration of both the mold A and the mold B.

The mold may be used only once and then discarded, or may be repeatedly reused.

In the shaping step, first, a substrate is prepared. In the embodiment shown in Fig. 1A and Fig. 1B, the substrate 10 is prepared as shown in (A) of Fig. 1Aand (A) of Fig. 1B.

Next, as shown in (B) of Fig. 1A and (B) of Fig. 1B, the transfer material T is applied onto the substrate 10.

The material of the substrate is not particularly limited as long as the material is a substrate that can be applied to manufacturing of the structure using the transfer material. Examples thereof include a glass substrate, a metal substrate, a resin substrate, and a substrate such as silicon (Si). The substrate may be a substrate that has light transmittance or a substrate that has no light transmittance (that is, a non-transparent substrate).

In the shaping step, one aspect of shaping the transfer material on the substrate is to press the transfer material applied on the substrate using the mold.

Examples of the transfer material application means include an inkjet head, a spin coater, a gravure coater, and the like.

In the embodiment shown in Fig. 1A, as shown in (B) of Fig. 1A, after the transfer material T is applied onto the substrate 10, the transfer material T may be pressed using the mold 100 which is the mold A so as to have the configuration shown in (C) of Fig. 1A. Thereby, the shape of the pattern portion of the mold 100 is transferred to the transfer material T.

In the embodiment shown in Fig. 1B, as shown in (B) of Fig. 1B, after the transfer material T is applied onto the substrate 10, the transfer material T may be pressed using the mold 200 which is the mold B so as to have the configuration shown in (C) of Fig. 1B. Thereby, the shape of the pattern portion of the mold 200 is transferred to the transfer material T.

In another aspect of shaping the transfer material on the substrate, in the shaping step, the mold is filled with the transfer material and then the mold is disposed on the substrate. The shaping step of the present aspect is performed using the mold A.

Specifically, instead of applying the transfer material T onto the substrate 10 ((B) of Fig. 1A), the transfer material T is directly filled in the mold 100, and the mold 100 filled with the transfer material T may be disposed on the substrate 10 so as to have the configuration shown in (C) of Fig. 1A. The mold 100 filled with the transfer material T may be disposed on the substrate 10 and may be then further pressed. Thereby, the shape of the pattern portion of the mold 100 is transferred to the transfer material T.

In another aspect of shaping the transfer material on the substrate, in the shaping step, the first member disposed on the substrate is filled with the transfer material, the second member is disposed on the first member filled with the transfer material so as to form a mold, and the formed mold is pressed. The shaping step of the present aspect is performed using the mold A.

Examples of the transfer material application means in the present aspect include an inkjet head, a squeegee, and the like.

Specifically, instead of applying the transfer material T onto the substrate 10 ((B) of Fig. 1A), for example, the first member 11 may be disposed on the substrate 10, the pattern portion having the through-hole of the first member 11 may be filled with the transfer material T, thereafter the second member 12 may be disposed on the first member 11 to assemble the mold 100, and then the mold 100 may be pressed so as to have the configuration shown in (C) of Fig. 1A. Thereby, the shape of the pattern portion of the mold 100 is transferred to the transfer material T.

In the shaping step, it is also preferable that, in a case of disposing the first member on the substrate, the first member and the substrate are immobilized by using magnetic force.

As a method of immobilizing the first member and the substrate by using magnetic force, in a case where the mold A is used, the magnet may be disposed on the side opposite to the side of the first member 11 of the substrate 10, in (C) of Fig. 1A. Further, in a case where the mold B is used, the magnet may be disposed on the side of the second member 12A opposite to the side of the first member 11, in (C) of Fig. 1B

In the shaping step, it is preferable that the transfer material is cured. The curing preferably includes at least one selected from a group consisting of curing and photocuring having a curing temperature of -65°C or higher and 300°C or lower, and more preferably includes photocuring.

In the photocuring, a photocurable composition (preferably, a UV curable composition) is used as the transfer material T, the transfer material T and the mold are brought into contact with each other, and then exposure is performed with light having a wavelength of 200 to 400 nm. Exposure conditions and exposure means may be appropriately selected in accordance with the photocurable composition to be used. Examples of the photocurable composition include PAK-01 and PAK-02 which are manufactured by Toyo Synthetic Industry Co., Ltd.

In a case where the photocuring is applied to the curing of the transfer material, the exposure may be performed in order from the substrate side or the mold side. In a case where the mold B is used, it is preferable that exposure can be performed in order from the substrate side. In a case of exposure from the substrate side, the substrate is a light transmittance substrate. In a case where the mold A is used for exposure from the mold side, at least the second member may be manufactured by using a light transmittance material. In a case where the mold B is used for exposure from the mold side, both the first member and the second member are manufactured by using the light transmittance material.

As the curing in the shaping step, it is also preferable that the curing temperature is -65°C or higher and 300°C or lower. The transfer material T used in this aspect can include thermoplastic resin or thermosetting resin.

In a case where the transfer material T including the thermosetting resin is used, the transfer material T (thermosetting resin or thermosetting resin composition) is brought into contact with the mold and then the transfer material T is heat-cured. Heating conditions and heating means may be appropriately selected in accordance with the transfer material T to be used. Examples of the thermosetting resin include polydimethylsiloxane (PDMS) and epoxy resin.

In a case where the transfer material T (that is, thermoplastic resin or thermoplastic resin composition) including the thermoplastic resin is used, injection molding can be used in the shaping step. In such a case, the transfer material T can be cured by melting the transfer material T including thermoplastic resin such as polycarbonate or cycloolefin polymer (COP), injecting the transfer material T into the mold tool in which the mold is set and filling the mold tool with the transfer material T, and cooling and solidifying the transfer material T.

### Exposure Step

In the exposure step, after the shaping step, by removing the second member from the specific mold, a part of the structure, on which the transfer material is shaped, is exposed or a part of the structure, on which the transfer material is shaped, and a part of the substrate are exposed.

In a case where the mold A is used, for example, as shown in (D) of Fig. 1A, the first member 11 is separated from the second member 12 and the second member 12 is removed. Thereby, a part of the surface of the structure S shaped from the transfer material T after the shaping step is exposed from the through-holes of the first member 11.

In a case where the mold B is used, as shown in (D) of Fig. 1B, the first member 11 and the second member 12A are separated from each other, and the second member 12A is removed. Thereby, a part of the surfaces of the substrate 10 and the structure S shaped from the transfer material T after the shaping step is exposed under the through-hole of the first member 11.

Means for separating the first member 11 and the second member 12 to remove the second member 12 is not particularly limited, and examples thereof include peeling removal using a hand-operated device, dissolution removal using a solvent, and the like. The same applies to the means for separating the first member 11 and the second member 12A to remove the second member 12A.

### Separation step

In the separation step, the first member and the structure are separated from each other by pressing at least a part of an exposed part of the structure or an exposed part of the substrate which is exposed through the exposure step.

The unexposed part of the structure after the exposure step tends to be firmly adhered to the first member. Thus, in a case where an attempt is made to separate the entire structure from the first member at one time, in some cases, the structure may be damaged. This tendency is particularly large in a case where the structure is a microstructre having a large aspect ratio.

In the separation step, by pressing at least a part of the exposed part of the structure or the exposed part of the substrate exposed through the exposure step, peeling, which acts as a so-called "wedge" that triggers the mold release, is applied between the unexposed part of the structure and the first member. Thus, the structure and the first member can be separated from each other while the damage to the structure is suppressed.

In the separation step, the surface treatment may be optionally performed after the exposure step, and the separation step may be performed after the surface treatment step. The surface treatment step will be described later.

The pressure for pressing is not particularly limited and can be appropriately set, for example, in accordance with the pressing means (pressing member, gas, liquid, etc.), such as the shape, size, and properties of the structure.

In the separation step, from the viewpoint of not damaging the structure, it is preferable that at least a part of the exposed part of the structure or at least a part of the exposed part of the substrate is pressed, such that the first member is separated from the structure, by using at least one selected from the group consisting of a pressing member, a gas, and a liquid that can be inserted into the through-hole of the first member.

From the viewpoint of manufacturing suitability, the pressing in the separation step more preferably includes pressing using a pressing member that can be inserted into the through-hole or a gas, and yet more preferably includes pressing using a pressing member.

From the viewpoint of convenience, a pressing pin is preferable as the pressing member capable of being inserted into the through-hole. By using the pressing pin, even the structure having the large aspect ratio is satisfactorily suppressed from being damaged during separation. In the present disclosure, the "pressing pin" means a member having a hardness capable of pressing the shaped structure and having a length capable of penetrating the through-hole of the first member of the specific mold.

In the aspect in which the mold A is used, it is preferable that a length of the pressing member along the pressing direction is longer than a penetration length of the through-hole of the first member along the pressing direction. Since the length of the pressing member along the pressing direction is longer than the penetration length of the through-hole of the first member along the pressing direction, the structure present in the through-hole can be reliably separated from the first member.

Here, the length of the pressing member along the pressing direction means a length of a portion inserted into the through-hole of the first member. The pressing member may have a portion that is not inserted into the through-hole (for example, a gripping portion, a connecting portion of a plurality of pressing portions, or the like). However, the length of the portion that is not inserted into the through-hole is not included in the length along the pressing direction of the pressing member.

The embodiment shown in Fig. 1A and the embodiment shown in Fig. 1B are examples in which the pressing member is used in the separation step.

In (A) and (F) of Fig. 1A, a protrusion portion (pressing pin) of an extrusion member 13A is inserted into an exposed part of the structure S through the through-hole of the first member 11, and is pressed in the direction of the arrow Y Thereby, the structure S, which is formed on the substrate 10, and the first member 11 are separated from each other.

As shown in (G) of Fig. 1A, the structure S, which is formed on the substrate 10, is obtained through the separation step.

Further, in (E) and (F) of Fig. 1B, a protrusion portion (pressing pin) of the extrusion member 13B is inserted into an exposed part of the substrate 10 through the through-hole of the first member 11, and is pressed in the direction of the arrow Y Thereby, the structure S, which is formed on the substrate 10, and the first member 11 are separated from each other. As shown in (G) of Fig. 1B, the structure S, which is formed on the substrate 10, is obtained through the separation step.

The gas is not limited as long as the gas is a gas that does not damage the structure, and may be selected in accordance with the structure to be manufactured. In a case where the structure is subjected to the surface treatment, the gas may be selected in accordance with the properties of the surface-treated layer. Examples of the gas include air, nitrogen gas, and argon gas, and air is preferable, from the viewpoint of safety.

The liquid is not limited as long as the liquid is a liquid that does not damage the structure, and may be selected in accordance with the structure to be manufactured. In a case where the structure is subjected to the surface treatment, the gas may be selected in accordance with the properties of the surface-treated layer. Examples of the liquid include water and a solvent such as ethanol, and water is preferable, from the viewpoint of safety.

In some aspects of the separation step, it is preferable to perform the pressing once on the entirety of the exposed part of the structure or the entirety of the exposed part of the substrate. By performing the pressing in an one-step operation, the structure and the first member can be efficiently separated. From the viewpoint of suppressing damage to the structure, it is preferable that the pressing is to uniformly apply pressure the entirety of the exposed part from the through-hole where the structure or the substrate is exposed.

Fig. 5 is a schematic cross-sectional view showing an example of an aspect in which the entirety of the exposed part of the structure is pressed once and separated by the one-step operation.

Fig. 5 shows an aspect after the second substrate is removed in the exposure step and before the separation step is performed. As shown in Fig. 5, the structure S is formed in the through-hole of the first member 11A disposed on the substrate 20, and a part of the structure S is exposed on a surface of the first member 11A opposite to the substrate 20. The first member 11A is the same member as the first member 11A shown in Figs. 3A and 3B.

The pressing member 13C has the same number of protrusion portions as the number of through-holes (that is, the number of formed structures S) of the first member 11A. A length of the pressing member 13C along the pressing direction is longer than a penetration length of the first member 11A along the pressing direction of the through-hole.

In the pressing of the present aspect, the entirety of the exposed part of the structure S is pressed once in the direction of the arrow Y using the pressing member 13C, and the structure S and the first member 11A are separated by the one-step operation.

In some aspects of the separation step, it is preferable that the pressing against the exposed part of the structure or the exposed part of the substrate is performed stepwise multiple times. In a case where the pressing is performed stepwise multiple times, damage to the structure can be more effectively suppressed. Further, it is preferable to perform the pressing stepwise multiple times in the following point. In a case where a plurality of structures having different characteristics (for example, a shape, properties, and the like) are provided, the pressing can be performed in accordance with the characteristics of the structure.

From the viewpoint of suppressing the damage to the structure, it is preferable that the pressing is to uniformly apply pressure to the exposed part to be pressed from the through-hole where the structure or the substrate is exposed.

The aspect of the pressing in a case where the pressing is performed in stepwise multiple times is not particularly limited. Two or more regions including the exposed part to be pressed may be set, and the pressing may be performed in accordance with the number of the set regions. For example, there may be an aspect in which the entire region where the exposed part to be pressed is present is divided into a central portion and an edge portion, the central portion is first pressed, and then the edge portion is pressed.

The multi-step pressures used for the pressing may be the same pressure in all the steps, or different pressures may be combined for each step.

From the viewpoint of suppressing damage to the structure even in a case where the pressing is performed in multiple steps, it is preferable that the pressing is to uniformly apply pressure to the exposed part to be pressed from the through-hole where the structure or the substrate is exposed.

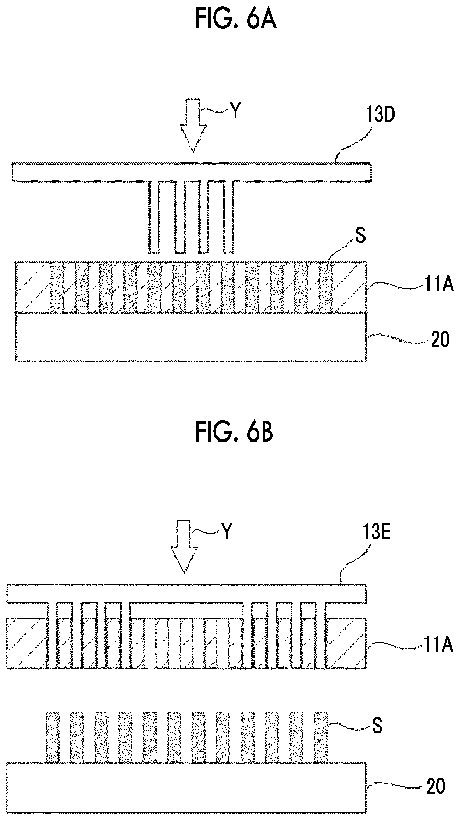

Figs. 6A and 6B are schematic cross-sectional views showing an example of an aspect in which the exposed part of the structure is pressed in multiple steps. In the present example, the pressing is performed in two steps.

Figs. 6A and 6B show an aspect after the second substrate is removed in the exposure step and before the separation step is performed. As shown in Fig. 6A, the structure S is formed in the through-hole of the first member 11A disposed on the substrate 20, and a part of the structure S is exposed on the surface of the first member 11A on the side opposite to the substrate 20. The first member 11A is the same member as the first member 11A shown in Figs. 3A and 3B.

The pressing member 13D is a pressing member used for pressing in the first step, and has the same number of protrusion portions as the number of through-holes located in the central portion among the number of through-holes of the first member 11A. A length of the pressing member 13D along the pressing direction is longer than a penetration length of the first member 11A along the pressing direction of the through-hole.

The pressing member 13E is a pressing member used for pressing in the second step, and has the same number of protrusion portions as the number of through-holes located in the edge portion other than the central portion in the number of through-holes of the first member 11A. A length of the pressing member 13E along the pressing direction is longer than a penetration length of the first member 11A along the pressing direction of the through-hole.

In the pressing of the present aspect, first, as shown in Fig. 6A, the exposed part of the structure S located at the central portion is pressed in the direction of the arrow Y by using the pressing member 13D, and the structure S at the central portion is released from the first member 11A. Next, as shown in Fig. 6B, the pressing member 13E is used to press the exposed part of the structure S located at the edge portion in the direction of the arrow Y, and the structure S at the edge portion is released from the first member 11A. As a result, the first member 11A is separated from all of the plurality of structures S shaped on the substrate 20.

### Other Steps

In the method of manufacturing the structure according to the present disclosure, other steps other than the transfer material provision step, the shaping step, the exposure step, and the separation step may be performed as desired. Examples of the other steps include the surface treatment step, the cleaning step, and the step of processing the structure after the separation step. The other steps are not limited to the examples.

### Surface Treatment Step

In the method of manufacturing the structure according to the present disclosure, the surface treatment may be performed on the surface of the exposed structure after the exposure step and before the separation step.

The surface treatment is preferably performed without separating the first member and the structure, and the surface treatment is more preferably performed on the surface of the exposed structure by using the first member as a mask. Through the surface treatment step, the surface treatment layer is locally formed on a part of the surface of the shaped structure or a part of the surface of the structure and the substrate.

Examples of the surface treatment include vacuum film formation treatment, coating treatment, ion irradiation treatment, etching treatment, and blasting treatment.

Examples of the vacuum film formation treatment include vacuum vapor deposition, sputtering, chemical vapor deposition (CVD), and atomic layer deposition (ALD).

Examples of the coating treatment include inkjet and spray coating.

Examples of the ion irradiation treatment include atmospheric pressure plasma treatment, oxygen plasma ashing, and UV ozone treatment.

Examples of the etching treatment include dry etching using gas and wet etching using a chemical liquid.

Examples of the blasting treatment include sandblasting treatment.

The treatment conditions and the treatment device for each of the above-mentioned treatments may be appropriately selected in accordance with properties of the target surface-treated layer.

### Cleaning Step

The method of manufacturing the structure according to the present disclosure may further include a step of cleaning the surface of the first member or the second member after the separation step. In particular, in a case where the first member is reused, the residue of the surface treatment is accumulated on the side of the first member facing the second member. Therefore, it is particularly preferable to include a step of cleaning the side of the first member facing the second member in such a case.

The cleaning means is appropriately selected in accordance with the surface treatment means, the material to be adhered, and the like. Examples of the cleaning means include wet cleaning using an acid, an alkali, an organic solvent, or the like; dry ice cleaning; cleaning using a laser; sandblast cleaning; plasma cleaning such as atmospheric pressure plasma and dry etching; and the like.

### Step of Processing Structure After Separation Step

Examples of the step of processing the structure after the separation step include sealing the structure (for example, a microchannel) using another member, incorporating the structure into another part, and cementing the structure. The above-mentioned surface treatment step may be performed on the structure after the exposure step and before the separation step.

### Other Matters Relating to Specific Mold

Hereinafter, the specific mold used in the method of manufacturing the structure according to the present disclosure will be further described.

### Other Modification Examples of Specific Mold

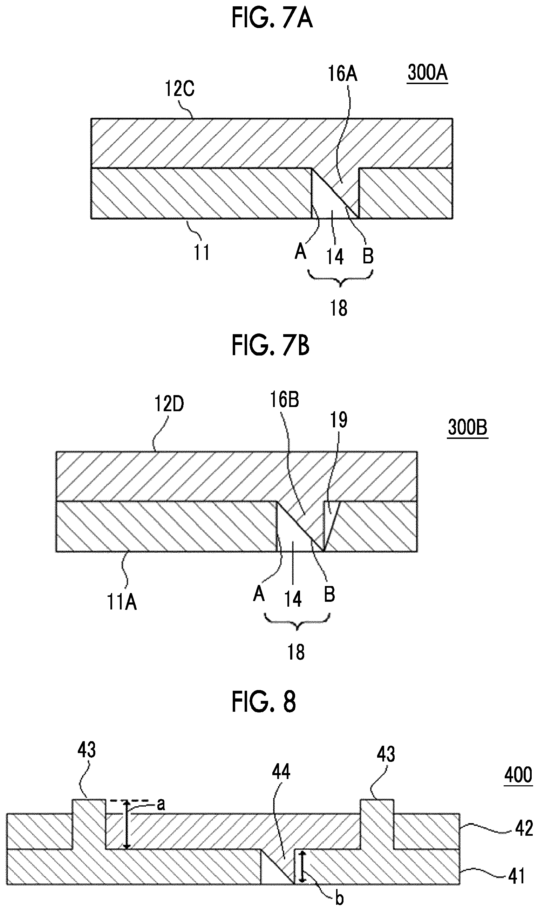

The mold 300A shown in Fig. 7A is one type of the mold A, and is configured to be the same as the mold 100 except the change in the following aspect. The second member 12C has a fitting portion 16A into which the through-hole 14 of the first member 11 is fitted, and the wall surface B includes the surface of the fitting portion 16A. In the mold 300, a region including the mold wall, in which the wall surface A and the wall surface B are continuously formed, constitutes a pattern portion 18.

As shown in Fig. 7A, in a case where the second member 12C has the fitting portion 16A, a structure having an inclined surface is shaped, and the second member 12 is separated and removed from the first member 11, and thereafter surface treatment can be locally and accurately performed on an inclined surface by using the first member 11 as a mask.

In the mold 300A, the fitting portion 16A is fitted into the inside of the through-hole 14 such that a part of the surface of the fitting portion 16A comes into contact with a part of the inner surface of the through-hole 14. However, there may be an aspect in which the fitting portion is fitted into the inside of the through-hole such that the fitting portion does not come into contact with the inner surface of the through-hole.

In the mold 300A, the through-hole of the first member and the fitting portion of the second member may further form a room separate from the room defined by the mold wall. By forming the room separate from the room defined by the mold wall, the first member and the second member can be easily separated from each other, in the exposure step. The specific mold of the present aspect is shown in Fig. 7B.

As shown in Fig. 7B, the mold 300B is configured by combining a first member 11A having a through-hole 14 and a second member 12D having a fitting portion 16B. A room 19 is formed separately from the room defined by the mold wall formed from the wall surface A of the through-hole 14 and the wall surface B which is a part of the surface of the fitting portion 16B. In the mold 300B, a region including the mold wall, in which the wall surface A and the wall surface B are continuously formed, constitutes a pattern portion 18.

### Material for Forming Specific Mold and Method of Manufacturing Specific Mold

The material for forming the first member and the second member of the specific mold is not particularly limited as long as the material is a material applicable to the formation of the mold, and may be an inorganic material or an organic material.

Examples of the inorganic material include a metal material, a glass material, and a ceramic material. Examples of the metal material include nickel, copper, and an alloy including two or more of the metals. Examples of the glass material include quartz, and examples of the ceramic material include silicon carbide (SiC).

Examples of the organic material include an organic material including a resin. Examples of the resin include resins such as silicone, polydimethylsiloxane (PDMS), polycarbonate, and cycloolefin polymer (COP).

The first member and the second member can be manufactured by, for example, lithography such as cutting, laser exposure; dry etching or wet etching; electrocasting, molding using the organic material including the resin; and the like.

Further, as an aspect, the first member and the second member may be manufactured separately, and then the two members may be combined to form a mold, or as an aspect, the second member may be formed on the first member to form a mold. Examples of the aspect in which the second member is formed on the first member include an aspect in which the second member is formed on the first member manufactured in advance by using the coating method or the like.

The thicknesses of the first member and the second member can be appropriately set in accordance with the intended purpose. For example, the thicknesses of the first member and the second member can be independently set in a range of 10 µm to 10 mm and may be set in a range of 100 µm to 600 µm.

The materials for forming the first member and the second member may be the same or different.

From the viewpoint of manufacturability and cost, it is preferable that the first member and the second member are made of the same material.

The first member and the second member may be formed of materials which have different elastic moduli from each other. By using materials which have elastic moduli different from each other, the degree of bending with respect to external force applied in the case of separating the first member and the second member differs between the first member and the second member. Therefore, the first member and the second member are easily separated.

Examples of the materials which have different elastic moduli include an aspect in which one is an inorganic material including a metal and the other is an organic material including a resin.

In an aspect in which the mold is formed by using materials which have different elastic moduli, the elastic modulus of the material constituting the first member may be greater than the elastic modulus of the material constituting the second member, or the elastic modulus of the material constituting the first member may be less than the elastic modulus of the material constituting the second member.

At least one of the first member or the second member may include a magnetic material, or both of the first member and the second member may include a magnetic material.

Examples of the magnetic material include metals such as nickel, cobalt, and iron, and alloys including two or more of the metals.

Since at least one of the first member or the second member includes the magnetic material, it is possible to improve immobilization between the first member and the second member or between the substrate on which the transfer material is disposed and the mold, by using the magnetic force from the outside.

In a certain aspect, the mold according to the present disclosure may be a mold in which the first member and the second member are immobilized by using the magnetic force. As the magnetic force, magnetic force generated from a magnet disposed outside the mold may be used. As the magnet, for example, a permanent magnet such as a neodymium magnet or an electromagnet can be used. The magnet may be disposed on either the first member side or the second member side of the mold.

### Release layer

Each of the first member and the second member may have a release layer in at least a partial region of the surface. It is preferable to provide the release layer in that it is easy to perform separation between the first member and the second member, or separation between the first member and the structure or substrate on which the transfer material is shaped.

Examples of the aspect, in which the first member and the second member have the release layer, include aspects shown in (1) or (2) below, or may be both of the aspects shown in (1) and (2). Only one of the first member and the second member may have the release layer, or both of the first member and the second member may have the release layer.

Aspect (1): A form in which the release layer is provided in at least a partial region of a surface in which the first member and the second member are in contact with each other. According to Aspect (1), the releasability at the interface between the first member and the second member in the exposure step is improved, and the separation between the first member and the second member is easier.

Aspect (2): A form in which the release layer is provided in at least a partial region of a surface in which the first member and the second member are not in contact with each other. According to Aspect (2), the releasability between the first member and/or the second member and the structure shaped from the transfer material in the exposure step or the releasability between the first member and the substrate in the separation step is improved, and separation of the 1-member and/or the second member from the structure or separation of the first member from the substrate is easier.

The release layer can be formed of a fluorine-contained release agent, for example, perfluoropolyether (PFPE) or polytetrafluoroethylene (PTFE). Further, as the release layer, an aspect formed by using diamond-like carbon (DLC) is also appropriate.

### Region in which Light is Transmitted in Second Member

In a case where a photocurable transfer material is applied as the transfer material, the second member may include a region that transmits light having at least a part of wavelengths in a range of wavelengths 200 to 400 nm. That is, the second member can be manufactured, for example, using the material that transmits light of at least a part of the wavelengths in the range of the wavelengths 200 to 400 nm (hereinafter, also referred to as a light transmittance material).

The region that transmits light of at least a part of the wavelengths in the range of wavelengths 200 to 400 nm may be at least a region corresponding to a position where the photocurable transfer material is disposed in the step of manufacturing the structure. At least a part of the second member may be manufactured using the light transmittance material, or the second member may be entirely manufactured using the light transmittance material.

There is an advantage in manufacturing the second member using a light transmittance material since exposure can be performed from the mold side in a case where a non-transparent substrate is used as the substrate on which the structure is provided.

Examples of the light transmittance material include a light transmittance resin material (for example, polydimethylsiloxane (PDMS), and cycloolefin polymer (COP)), quartz glass, and the like.

### Alignment Portion

In the specific mold, it is preferable that at least one member of the first member and the second member has an alignment portion which aligns the members with each other. By providing the alignment portion, it is possible to accurately align the first member and the second member. The specific mold may have an alignment portion in either form of the mold A or the mold B.

It is preferable that the alignment portion has an aspect in which the first member and the second member are fitted to each other. From the viewpoint of accuracy of alignment, it is preferable that the alignment portion has an aspect in which one of the first member and the second member has a projected portion and the other thereof has a recessed portion.

The number of alignment portions may be one, but is preferably two or more from the viewpoint of improving an accuracy of alignment.

The alignment portion may be, for example, in a form in which one of the first member and the second member has a projected portion and the other thereof has a recessed portion or a penetration portion.

In a certain aspect of the mold A, from the viewpoint of improving the accuracy of alignment and not damaging the pattern portion, the second member has the fitting portion to be fitted into the through-hole of the first member. In the alignment portion, in the cross-sectional view in the thickness direction, it is preferable that the first member has a projected portion having a large length with respect to the length of the fitting portion of the second member and the second member has the recessed portion.

Fig. 8 is a schematic cross-sectional view showing an example of the specific mold (mold A) having the alignment portion. In the example shown in Fig. 8, the mold 400 has two alignment portions 43 composed of a projected portion of the first member 41 and a penetration portion as a recessed portion of the second member 42. A length a of the projected portion is configured to be greater than a length b of the fitting portion 44.

According to the mold and the method of manufacturing the structure of the present disclosure, it is possible to form a microstructre and to perform surface treatment on a part of the surface of the structure. Therefore, the mold and the method of manufacturing the structure of the present disclosure can be usefully applied to medical/bio-applications such as a microchannel and a cell culture vessel; optical applications such as a microlens and a micromirror; and the like.

### Explanation of References

100, 200, 300A, 300B, 400: mold
10, 20: substrate
11, 11A, 41: first member
12, 12A, 12C, 12D, 42: second member
13A, 13B, 13C, 13D, 13E: pressing member
14: through-hole
15: protrusion portion
16A, 16B, 44: fitting portion
18: pattern portion
19: room
43: alignment portion
a, b: length
A: wall surface A
B: wall surface B
S: structure
T: transfer material
Y: Y direction

## Claims

1. A method of manufacturing a structure comprising:
a step of providing a transfer material;
a step of shaping the transfer material on a substrate by using a mold for structure shaping, which has a first member that has two main surfaces and a through-hole which penetrates through the main surfaces and a second member that blocks the through-hole, and in which the first member and the second member are combined such that a wall surface A, which is a part of a surface of the first member, and a wall surface B, which is a part of a surface of the second member, are made continuous to form a mold wall;
a step of exposing a part of the structure on which the transfer material is shaped, or a part of the structure on which the transfer material is shaped and a part of the substrate by removing the second member from the mold; and
a step of separating the first member and the structure from each other by pressing at least a part of an exposed part of the structure or an exposed part of the substrate.

2. The method according to claim 1, wherein in the step of separating the first member and the structure from each other, pressing against at least a part of the exposed part of the structure or at least a part of the exposed part of the substrate is performed by using at least one selected from the group consisting of a pressing member, a gas, and a liquid capable of being inserted into the through-hole of the first member.

3. The method according to claim 1 or 2, wherein in the step of separating the first member and the structure from each other, pressing against an entirety of the exposed part of the structure or an entirety of the exposed part of the substrate is performed once.

4. The method according to claim 1 or 2, wherein in the step of shaping the transfer material, a plurality of the structures are shaped, and in the step of separating the first member and the structure from each other, pressing against the exposed part of the structure or the exposed part of the substrate is performed stepwise multiple times.

5. The method according to any one of claims 1 to 4, wherein the pressing includes pressing using the pressing member.

6. The method according to claim 5, wherein the pressing member is a pressing pin.

7. The method according to claim 5 or 6,
wherein the mold for structure shaping is a mold for structure shaping in which the wall surface A is a surface of the through-hole and the wall surface A and the first member and the second member are combined such that the wall surface A and the wall surface B are made continuous to form the mold wall, and
a length of the pressing member along a pressing direction is longer than a penetration length of the through-hole of the first member along the pressing direction.

8. The method according to any one of claims 5 to 7,
wherein the mold for structure shaping is a mold for structure shaping in which the wall surface A is a surface of the through-hole and the wall surface A and the first member and the second member are combined such that the wall surface A and the wall surface B are made continuous to form the mold wall, and
the through-hole of the first member includes a through-hole having an aspect ratio of 2 to 20, which is a penetration length with respect to an opening width.
